**Europäisches Patentamt**

**European Patent Office**

**Office européen des brevets**

(19)

(11) Veröffentlichungsnummer:

# 0 034 112
## A1

(12)

# EUROPÄISCHE PATENTANMELDUNG

(21) Anmeldenummer: **81730003.1**

(51) Int. Cl.³: **H 03 K 3/26,** H 04 B 1/16

(22) Anmeldetag: **10.01.81**

---

(30) Priorität: **31.01.80 DE 3003738**

(43) Veröffentlichungstag der Anmeldung: **19.08.81**
**Patentblatt 81/33**

(84) Benannte Vertragsstaaten: **AT CH DE LI NL**

(71) Anmelder: **Licentia Patent-Verwaltungs-GmbH, Theodor-Stern-Kai 1, D-6000 Frankfurt/Main 70 (DE)**

(72) Erfinder: **Lotz, Alfred, Ing.-grad., Büchsenweg 14, D-1000 Berlin 51 (DE)**
Erfinder: **Meisel, Rainer, Ing.-grad., Burgstrasse 20, D-8011 Pöring (DE)**

(74) Vertreter: **Schickle, Gerhard, Dipl.-Ing. et al, Licentia Patent-Verwaltungs-GmbH Theodor-Stern-Kai 1, D-6000 Frankfurt/Main 70 (DE)**

---

(54) **Elektronische Verbindungsschaltung.**

(57) Die Erfindung betrifft eine elektronische Verbindungsschaltung zum rückwirkungsfreien Abnehmen von durch Wechsel- oder Gleichspannungen repräsentierten Kriterien aus Steuerungs- und Überwachungsanlagen sowie deren Aufbereitung in logische Signale und Weiterleitung an andere Verarbeitungssysteme, zum Beispiel Prozeßrechner. Die Erfindung besteht darin, daß die Spannung einer Meldelampe an die Eingänge einer Eingangsstufe gelegt wird. Die Eingangsstufe besteht aus einem hochohmigen Widerstand, einer Diode und einem Kondensator und ist mit einem Opto-Koppler verbunden. Dieser ist mit einer Mono-Flopstufe verbunden, die einen Tiefpaß, ein RC-Glied und ein Zeitglied enthält. An die Mono-Flopstufe ist zur Stromversorgung eine Spannungskonstanthaltestufe angeschlossen aus einem Widerstand, einer Diode und einem Kondensator. Außerdem ist an die Mono-Flopstufe eine Verstärkerstufe angeschlossen, an deren Ausgängen ein verstärktes statisches Ausgangssignal abnehmbar ist.

- I -

Elektronische Verbindungsschaltung

Die Erfindung betrifft eine elektronische Verbindungsschaltung nach dem Oberbegriff des Patentanspruchs.

Bei automatisch ablaufenden Prozessen gelangen Rückmeldungen von den Stellorganen auf eine Kontrollanzeigeeinrichtung, aus der man den jeweiligen Zustand der
Stellorgane ersehen kann. In vielen Fällen sollen diese
Rückmeldungen auch einem Prozeßrechner zugeführt werden,
der sie weiterverarbeiten soll. Zur Verbesserung und Rationalisierung in der Betriebsführung werden bei Prozeßführungen in immer stärkerem Maße technische Systeme eingesetzt, die das Personal in ihrer Arbeit unterstützen
und weitgehend von Routinehandlungen entlasten. Die Meldespannungen können von einem Prozeßrechner jedoch vielfach nicht direkt verarbeitet werden, da sie z. B. in
einem Spannungsbereich zwischen 6 und 3o V als Wechselstrom vorliegen. Ein Rechner arbeitet jedoch mit logischen Signalpegeln. Durch die Meldungsabnahme soll die Überwachungskontrolleinrichtung nicht beeinträchtigt werden und auch ein Ausfall der Spannungsversorgung muß überbrückt werden können. Bisher wurden solche Meldeabnahmen mit Relaisschaltungen vorgenommen, die jedoch störanfällig sind, nur eine begrenzte Lebensdauer und einen großen Platzbedarf haben.

Die Aufgabe besteht daher darin, eine elektronische Verbindungsschaltung zu schaffen, die störsicher und rückwirkungsfrei Wechselstromspannungen innerhalb eines grossen Spannungsbereiches in für Prozeßrechner verarbeitbare logische Signale umwandelt und eine geringe Belastung der Meldungen durch geringen Leistungsbedarf der Eingangsstufe gewährleistet.

Die Aufgabe wird nach der Erfindung durch die im Patentanspruch angegebenen Maßnahmen gelöst.

Die Erfindung wird im folgenden an einem Ausführungsbeispiel anhand von Zeichnungen näher erläutert.

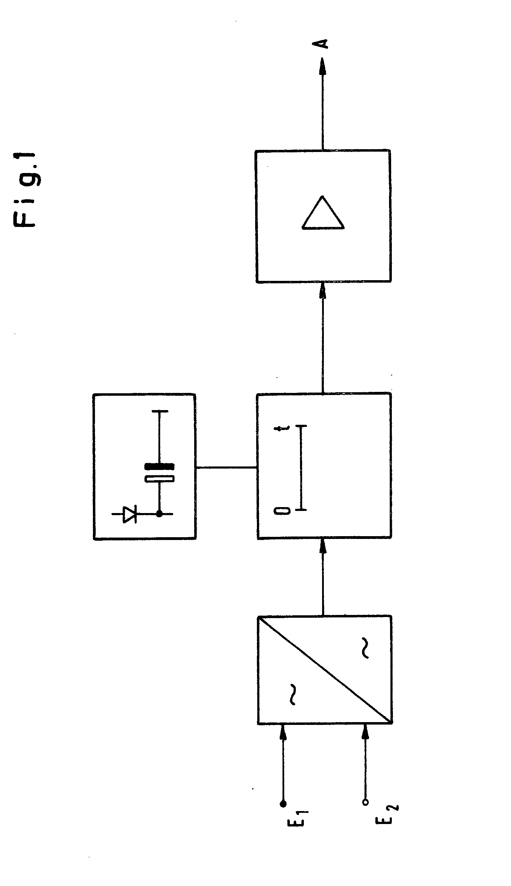

In Fig. 1 ist ein Blockschaltbild dargestellt mit einer Eingangsstufe 1 und den Eingängen E1, E2. Diese ist verbunden über eine Monoflopstufe 2 mit einer Ausgangsverstärkerstufe 3 mit dem Ausgang A. Die Monoflopstufe 2 wird von einer Spannungskonstanthaltestufe 4 gespeist.

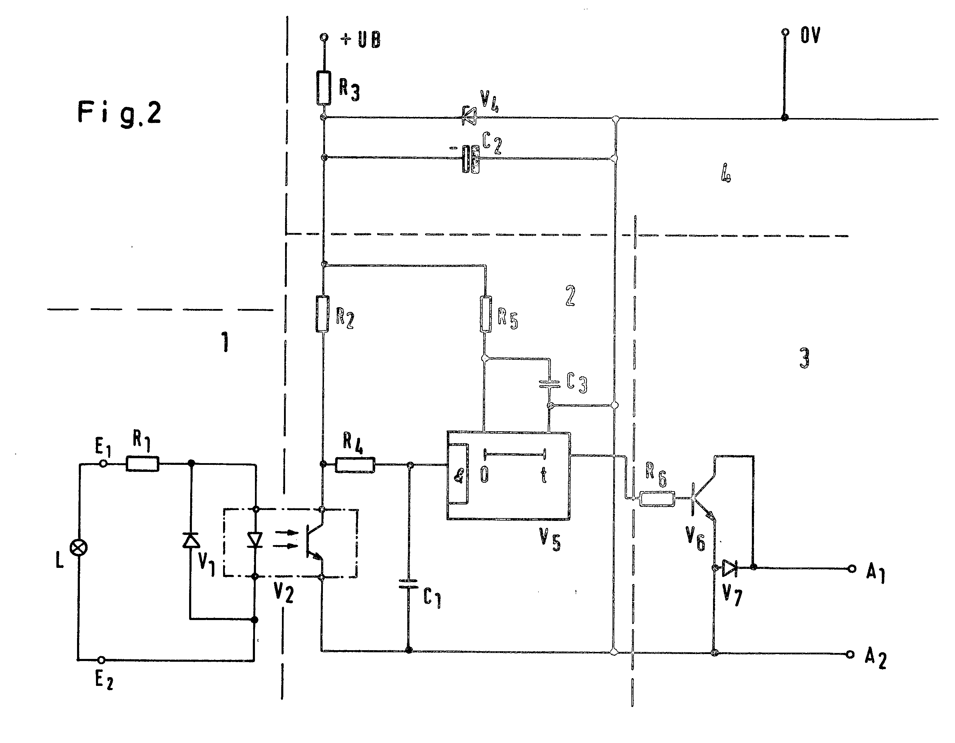

In Fig. 2 werden die vier Stufen der elektronischen Verbindungsschaltung näher dargestellt. In dem Ausführungsbeispiel wird die Spannung einer Meldelampe L an die Eingänge E1, E2 der Eingangsstufe 1 gelegt. Diese besteht aus einem hochohmigen Widerstand R1, einer Diode V1 und einem Optokoppler V2. Die Diode V1 soll verhindern, daß die eine Halbwelle des Stroms auf den Optokoppler gelangt. Der Optokoppler wird in Funktion gesetzt, sobald die Meldelampe angesteuert wird, und zwar sowohl bei Ruhiglicht als auch bei Blinklicht.

Der Optokoppler ist mit einer Monoflopstufe 2 verbunden. Diese bewirkt eine Störimpulsunterdrückung durch einen Tiefpaß aus dem Widerstand R4 und dem Kondensator C1. Durch ein angeschaltetes RC-Glied aus dem Widerstand R5 und dem Kondensator C3 ist ein Spannungsausfall überbrückbar. Die Monoflopstufe 2 erhält ein verzögertes Signal und hält mit Hilfe des Zeitgliedes ein statisches Ausgangssignal aufrecht.

Dieses Ausgangssignal wird nun auf eine Verstärkerstufe geführt, die aus einem Widerstand R6, einem Transistor V6 und einer Diode V7 besteht.

Zur Stromversorgung der Monoflopstufe 2 dient die Spannungskonstanthaltestufe 4, die aus einem Widerstand R3, einer Diode V4 und einem Kondensator C2 besteht. Die Spannungskonstanthaltestufe liegt an der Betriebsspannung UB. Falls diese kurzzeitig ausfallen sollte, wird die Versorgung der Monoflopstufe trotzdem aufrecht erhalten durch die Ladung des Kondensators C2. Die Diode V4 dient zur Stabilisierung.

Die elektronische Verbindungsschaltung nach der Erfindung ist wirtschaftlich, wartungsfrei, störspannungsfest, hat nur einen geringen Aufwand und Platzbedarf und ist in Hybridtechnik als integrierte Schaltung ausführbar.

- - - - -

Patentansprüche

1. Elektronische Verbindungsschaltung zum rückwirkungsfreien Abnehmen von durch Wechsel- oder Gleichspannungen repräsentierten Kriterien aus Steuerungs- und Überwachungsanlagen sowie deren Aufbereitung in logische Signale und Weiterleitung an andere Verarbeitungssysteme, zum Beispiel Prozeßrechner, gekennzeichnet durch folgende Maßnahmen:

a) Die Spannung einer Meldelampe ist an die Eingänge einer Eingangsstufe gelegt,

b) die Eingangsstufe, bestehend aus einem hochohmigen Widerstand, einer Diode und einem Kondensator ist mit einem Opto-Koppler verbunden,

c) der Opto-Koppler ist mit einer Mono-Flopstufe verbunden, die einen Tiefpaß, ein RC-Glied und ein Zeitglied enthält,

d) zur Stromversorgung der Mono-Flopstufe dient eine Spannungskonstanthaltestufe aus einem Widerstand, einer Diode und einem Kondensator,

e) an die Mono-Flopstufe ist eine Verstärkerstufe angeschlossen,

f) das verstärkte statische Ausgangssignal steht an den Ausgängen der Verstärkerstufe an.

2. Elektronische Verbindungsschaltung nach Anspruch 1, dadurch gekennzeichnet, daß ihre Eingangsstufe derart ausgelegt ist, daß sie in einem sehr großen Bereich der die abzunehmenden Kriterien repräsentierenden Spannungen arbeitet und nur einen geringen Leistungsbedarf hat.

0034112

Fig.1

Fig.2

### Europäisches Patentamt
## EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | CH - A5 - 559 988 (WESTINGHOUSE)<br><br>+ Spalte 1, Zeile 26 - Spalte 2, Zeile 13; Spalte 2, Zeilen 42-54; Spalte 3, Zeilen 1-39; Fig. 1,3 +<br><br>-- | 1,2 |
| | AT - A - 319 385 (SIEMENS)<br><br>+ Seite 4, Zeile 13-Seite 7, Zeile 25; Fig. 3,4 +<br><br>-- | 1 |
| | DE - A1 - 2 610 762 (STANDARD)<br><br>+ Seite 6, Zeile 9 - Seite 7, Zeile 11; Fig. 1 +<br><br>-- | 1 |
| | DE - A1 - 2 556 379 (LICENTIA)<br><br>+ Seite 3, Zeile 26 - Seite 4, Zeile 36; Fig. 1 +<br><br>---- | 1 |

**KLASSIFIKATION DER ANMELDUNG (Int. Cl.3)**

H 03 K 3/26
H 04 B 1/16

**RECHERCHIERTE SACHGEBIETE (Int. Cl.3)**

H 02 B 1/00
H 02 B 15/00
H 02 J 13/00
H 03 K 3/00
H 03 K 17/00
H 04 B 1/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 01-04-1981 | PIRKER |

EPA form 1503.1  06.78